# EUROPEAN PATENT APPLICATION

(11) **EP 3 301 462 A1**
(43) Date of publication of application: **04.04.2018**
(21) Application number: 17191497.1
(22) Date of filing: 15.09.2017
(51) Int. Cl.: G01R 31/02, G05B 19/042, G01R 31/08, G05B 23/02, G05B 19/418, H01B 7/32

(54) **A MONITORING AND ALERT SYSTEM FOR INDUSTRIAL CABLES**

(30) Priority: 16.09.2016 IT 201600093633
(71) Applicant: Tecnikabel S.p.A., 10121 Torino (IT)
(72) Inventor: GARIBOLDI, Roberto, 26836 Montanaso Lombardo (IT)
(74) Representative: Nannucci, Lorenzo

(57) **Abstract**

The present invention refers to the field of industrial automation, with particular reference to industrial robotics and handling in general. In this field, in the present case, cable chains or sheaths for transporting and containing cables, cable bundles or flexible hoses are particularly relevant, said cables or hoses being led to the robotic or handling systems in which they are used. It is well known to those skilled in the art that the cables or hoses transported and housed in sheaths or chains are protected from external agents that could cause abrasions or breakages, but are still subjected to mutual rubbing and rubbing against the inner wall of said sheaths or chains. Moreover, the environments in which said cable means are used are harsh environments, so that the cable sheaths or chains are also subjected to shocks and strong external stresses and said stresses may, and often do, reverberate and cause equivalent damages to the cables or hoses they contain. The object of the present invention is a monitoring and alert system to check the actual state of use and wear of an industrial cable.

## Description

The present invention refers to the field of industrial automation, with particular reference to industrial robotics and handling in general.

In this field, in the present case, cable chains or sheaths for carrying and housing cables, cable bundles or flexible hoses are particularly relevant, said cables or hoses being led to the robotic or handling systems in which they are used.

It is well known to those skilled in the art that the cables or hoses carried and housed in sheaths or chains are protected from external agents that could cause abrasions or breakages, but are still subjected to mutual rubbing and rubbing against the inner wall of said sheaths or chains. Moreover, the environments in which said cable-carrying means are used are harsh environments, so that the cable sheaths or chains are also subjected to shocks and strong external stresses and these stresses may, and often do, reverberate and cause corresponding damages to the cables or hoses housed therein.

It is also well known to those skilled in the art that the use of these chains and sheaths is widespread in automatic, or not-automatic, production lines and that the correct operation of each cable must be best guaranteed not to stop the production of the specific item, since stopping the whole production line to replace a single piece would cause huge economic losses.

In this regard, the industrial automation market, including fields such as robotics and manufacturing industry in general, is evolving towards use of sensors designed to control the operation of the elements of the manufacturing lines, as precisely as possible.

In the present case, with reference to the cables housed in cable chains that are a source of power supply for all industrial automation equipment, known systems that have been proposed for example count the number of cycles a given cable undergoes in a manufacturing line, knowing the cable material and thus calculating its useful average lifetime. This method, however useful, is based on empirical and statistical data without taking into account any other possible stress factor of the cable.

For example, a presently proposed innovative system to monitor these cables comprises the use of sensors arranged at said cable chains to monitor, if necessary, the stresses applied to said chains comprising said cables. One or more of these systems have in common the fact that monitoring substantially always occurs at the sheath or chain housing the cables, so that the collected data show the operating state of the cable chain, which has completely different physical characteristics with respect to the cables housed therein. In fact, while monitoring the chain it is not possible to have any information about operating state, wear, stresses, etc. of the cables it houses.

Therefore, these systems are not particularly relevant in the present case, since the present invention concerns the actual evaluation of the wear and operating conditions of the cables housed in the cable chains or sheaths for industrial use, or of cables for any use in industrial automation, even when not housed in special sheaths or chains.

The present invention more particularly concerns cables and alarm systems in case of wear or tear of the same cables.

In this regard, a plurality of prior art alarm devices and systems alerting in case of wear or damage to cables or wires for civil or domestic use are already known. In any case, even if these cables appear at first glance similar to those relevant to the present invention, they are in fact completely different from the cables relevant to the present invention, since their physical and structural characteristics, such as breakdown loads, degree of flexibility, delivered power, type of cable, material of the cables for domestic or civil use, etc. are, as already known to those skilled in the art, quite different from an engineering point of view from the industrial cables relevant to the present invention. This relates to the stresses to which they are subjected, which also depend on the size, weight, diameter of the cables, as well as, of course, to transport loads, materials, etc.

In any case, for the sake of completeness, it is reported a prior art example relating to a domestic cable wear or tear control device, which describes in particular a domestic cable comprising an inner cover and an outer cover. Between these two covers, two conductors are wound on the cable and are inserted on an inner insulating layer of the same cable. These conductors, in this case two wires, form a complete circuit since they are connected to a loop device and to a detector, which is connected in turn to a power outlet, to an alarm bulb and to a buzzer, these devices forming a closed circuit. The system substantially evaluates the Ohmic resistance value. In the event of a cable damage, the change in the impedance value causes the failure. Nothing is said about the detection system, nor is it given any real working detail thereof that, as any person skilled in the art knows, may be determined by cable length, alert threshold values, etc. and may considerably vary according to these parameters. The system is substantially suited only to a classic multi-plug distribution device for domestic use.

Domestic cables, or cables that are not particularly dedicated to industrial automation, are obviously much less and differently stressed if compared to other industrial cables. With reference to the example, which is just one of the prior art examples relating to the domestic field, the system appears extremely complex and scarcely functional in spite of the simplicity of the device.

Further examples describe devices or systems that evaluate cable colour alterations, or include means embedded in insulating layers within the same cables comprising conductive elements and insulating elements for the cables with respect to the outside. Some of these systems evaluate the temperature variations in the cable, others use a plurality of wires wound around the cables connected to suitable control lines, knowing the theoretical control value for each line, with particular reference to specialized fields, such as the railway sector, which mandatorily adopt special operating and control conditions. It is clear that the problem of detecting cable wear or malfunctions in order to avoid unexpected breakings, with their related problems, is a highly discussed topic. Moreover, it is also clear that, due to the wide variety of cables suitably developed for dedicated specialized sectors, each of these cables or cable sets, depending on the sector, requires different devices or systems to carry out proper operation and pre-alarm controls signalling wear or malfunctions due e.g. to shocks, flexural stresses, insulation-efficiency variations, etc.

Consequently, it is necessary to create control devices and systems dedicated to specific sectors so that these controls have a concrete applicability and industrial utility.

Indeed, as already known to those skilled in the art, to assess how to act on a specific cable, including checks and controls, the following features have to be known: the type of copper strand, the roping step, the type of internal insulation, the insulation voltages, the nature of the outer sheath, the cable usage patterns, e.g. static for the civil environment or dynamic for the industrial environment, and of course the certification parameters that the specific cable must meet.

Specifically, in the reference field relevant to the present invention, namely the industrial and robotic automation field, motor power supply and control cables, input/output cables and auxiliary cables used in movable applications (linear if inserted in cable chains or freely twisting or inserted in hoses) are widely used. These movements result in a continuous or temporary friction between the cables and/or the external bodies containing them (guides, cable chains or hoses) that can cause an abrasion first of the outer sheath and then of the inner conductors, giving rise to a malfunction or a complete breakage. Such extremely disadvantageous breakages cause costly machine stops or even manufacturing line stops.

The monitoring systems currently available in the field relevant to the present invention require a visual inspection of the state of the cables by the individual operators. This is often ineffective to prevent breakages. An alternative is predicting a maximum "lifetime" of the cable and suggesting its preventive replacement after a certain operating period, in the most delicate cases possibly by counting the number of working cycles of these cables and making assessments based on mere statistical calculations and, disadvantageously, not on actual measurements.

An object of the present invention is a monitoring and alert system for preventing cable damages that solves the problems and compensates for the shortcomings described above.

Therefore, an object of the present invention is a monitoring and alert system for preventing cable damages suitable for industrial automation and robotics.

A further object of the present invention is a monitoring and alert system for industrial cables suitable for cables for dynamic uses.

An object of the present invention is a simple and reliable system.

A further object of the present invention is a monitoring and alert system specifically dedicated to cables and to a real-time evaluation of the actual conditions of use and lifetime of one or more cables.

A further object of the present invention is an industrial monitoring and alert system for continuous remote monitoring.

A further object of the present invention is a system that is inexpensive, reliable and simple to install.

These and further objects will be achieved by means of an innovative monitoring and alert system for industrial cables comprising at least one or more conductors to be arranged along the length of an industrial cable. These conductors are interposed between a first and a second insulating layer enveloping said cable, said conductors being connected to form a closed circuit and said system further including means for detecting the opening of said circuit. Particularly advantageously, the industrial monitoring and alert system includes detection means for monitoring in real time the state of the circuit formed by said conductors during the dynamic operating phase of said industrial cable.

More advantageously, said industrial monitoring and alert system includes means for the real-time transmission of said data to one or more control and monitoring units of said data, such as electronic control units.

Particularly advantageously, said means for real-time data transmission are "smart" devices capable of monitoring parameters related to the controlled cable during its operation to evaluate the actual conditions of use of said cable. Therefore, said smart device can particularly advantageously check the closing of the circuit formed by the at least two conductors arranged along the length of the cable and covering the largest possible exposed area of the outer surface of the cable.

Furthermore, said at least one smart device may advantageously be provided with at least one own power supply battery to be independent of the remaining equipment.

Moreover, said smart device may advantageously include an accelerometer to monitor the number of working cycles of the cable, thus allowing knowing in real time the functional wear of the cable related to its life cycles.

A further advantageous variant of said smart device may optionally include means for real-time monitoring the cable temperature to assess whether the cable is in severe thermal conditions. In particular, one or more sensors can be applied along the cable or to the smart device to evaluate the ambient temperature at the cable work site. More advantageously, in some operating variants, said monitoring and alert system for said dynamic industrial cables includes one or more accelerometers integral with said one or more monitored cables for recording in real time the stress due to the dynamic stresses on the cable deriving from the movement to which the cable is subjected. Consequently, a duration analysis, based e.g. on previous experiences, in turn based on the real-time counting of the cycles, will particularly advantageously allow a calculation of the residual lifetime of the cable, which could be worn by possible frictions due to its sliding within a sheath or chain, or by its bending, especially at bending points of the cable, as well as by stresses due to starting accelerations or stopping decelerations.

The described variant may be an addition to a particularly preferred embodiment of the innovative monitoring and alert system described by the present invention for detecting in real time the wear of the cable and consequently the interruption of the circuit formed by the two conductors. Particularly advantageously, the circuit forming part of the innovative monitoring and alert system is obviously the first to break off in case of wear. Therefore, it breaks or is damaged before the cable, and being monitored by the smart monitoring device, said device receiving the corresponding signal of wear/break of the monitoring circuit will send an alert signal and a cable replacement alarm.

Therefore, thanks to the innovative monitoring and alert system for industrial cables described in the present invention, comprising at least said conductors connected to form at least one closed circuit and at least one smart device for monitoring in real time the state of the circuit, possibly together with other parameters relating to said cables, it will advantageously be possible to have a monitoring system based on actual and reliable data directly related to the industrial cables possibly housed in suitable sheaths or cable chains. This system will particularly advantageously prevent the cable from breaking, thus avoiding expensive manufacturing stops or malfunctions in the manufacturing chains.

These and further advantages obtained through the innovative monitoring and alert system for industrial cables described by the present invention will be further described and illustrated by the description of the accompanying drawings, in which:
Figure 1a is a section of a cable housing a part of the monitoring and alert system;
Figure 1b is the same embodiment of Fig. 1a in an exploded view;
Figure 2a is a particularly preferred embodiment of a part of said cable monitoring and alert system for industrial cables;
Figure 2b is a further preferred embodiment of a part of said cable monitoring and alert system for industrial cables;
Figure 3 is a further preferred embodiment of a part of said monitoring and alert system for industrial cables.

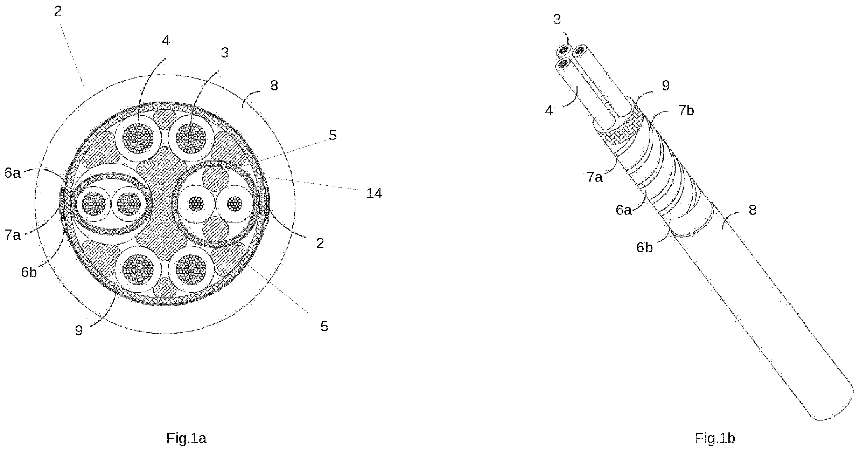

Referring to Figure 1, it shows a section of an example of a multipole industrial cable 2 suitable for the monitoring and alert system 1 for industrial cables described by the present invention. In particular, said multipole cable 2 comprises inside it a plurality of further conductive cables 3, said cables 3 being usually sheathed and/or shielded by means of a special shielding material 4. The main structure of said multipolar cable 2 may further comprise material 5, e.g. reinforcing plastic. Said cables 2, e.g. multipole cables, usually comprise a layer of inner insulating material 6a and a layer of outer insulating material 6b. Moreover, they generally comprise a protective outer sheath 8 and an outer shield 9 arranged between said first layer of insulating material 6a and the inner structure of the multipole cable 2.

In this case, the monitoring and alert system 1 described in the present invention involves the introduction of at least one pair of conductors or conductive plates 7a and 7b between said at least one first layer of insulating material 6a and said at least one second layer of insulating material 6b. Said materials may obviously be of any suitable nature.

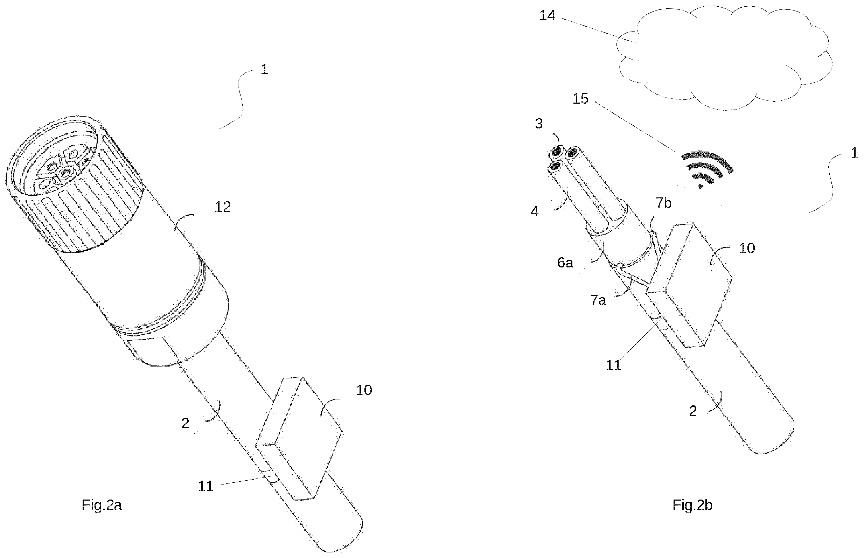

Said at least one pair of conductors or conductive plates 7a and 7b are preferably wound coil-like along the length of the industrial cable 2 as shown in Figure 2, which is a perspective view of an example of a multipole industrial cable 2 suitable for the purpose of the present invention. Said at least one pair of conductors or conductive plates 7a and 7b may also be arranged along the cable following its longitudinal development or cable length. In this case, in order to have the maximum coverage of the cable surface, it would be preferable to have at least two pairs of conductors along the whole length of the cable and forming at least one further electrically closed circuit.

Said modification may advantageously be carried out on any industrial cable without varying its general electrical, mechanical, etc. characteristics. Moreover, said modification may be carried out at a very low cost. The cables relevant to the present invention, as previously stated, are particular cables suitable for a dynamic, linear or twisting use, in particular usually (but not necessarily) together with cable chains or sheaths for housing them. A functionally effective management mode of said cables has to be carefully planned based on the type of the cables, so that the management of an industrial cable 2 is necessarily different from the one of a cable for domestic or civil use.

Referring now to Figures 2a and 2b, they show with more completeness two examples of two particularly preferred embodiments of the innovative monitoring and alert system 1 described in the present invention. In particular, Figure 2a is an example (not to scale, for the sake of descriptive clarity) of a smart device 10 included in the described innovative monitoring and alert system 1. Said at least one smart device in this case is connected by any suitable connecting means 11 to at least an industrial cable 2. With reference to Figure 2a, said cable further comprises at least one connector 12. In this example, it has a circular shape, but it may be rectangular, with a clamp or have any suitable shape. As already known, said connectors 12 are suitable for connecting said one or more industrial cables 2 to the respective devices to be supplied or, for example, to the devices by which the cables are supplied. Advantageously, said smart device 10 can control at least that the conductor pair 7a and 7b always forms a closed circuit. Said at least one pair of conductors 7a and 7b, e.g. wound along the length of the cable keep an electrically closed circuit if the industrial cable 2 works under optimum conditions. If, on the other hand, said cable 2 is worn because of its prolonged use or friction or continuous bending or twisting efforts, etc., said pair of conductors housed immediately below the protective sheath 8 of the cable, e.g. between said at least one outer insulating layer 6b and one inner insulating layer 6a, will be among the first sensitive elements of the cable to be possibly affected in case of wear. Therefore, they will be the first element sensitive to the optimal operation of the cable to be subjected to interruptions before such wear may damage the sensitive inner structure of the cable 2 with the aforesaid extremely serious consequences for the manufacturing continuity. Particularly advantageously, said smart device 10 will be able to control in real time the conditions of the electrical circuit formed at least by said pair of conductive plates 7a and 7b. More advantageously, said smart device 10 of said system 1 comprises means for transmitting said data, at least in wireless mode, to any suitable further detection system for receiving said data. Said monitoring and alert system 1, therefore, will particularly advantageously alert in real time to the wear conditions of an industrial cable 2. In particular, each industrial cable is suitable to be monitored by said innovative system 1 since positioning said system 1 on said cables is extremely simple and effective. Said device may advantageously be housed on the cable 2, or close to it, or on the connector of said cable 2, without thereby causing the minimum encumbrance or hindrance to the industrial cable 2.

Figure 2b shows in more detail an example of connection between said smart device 10 and said industrial cable 2. In particular, it shows an example of how said smart device 10 is connected to said pair of conductors 7a and 7b. The monitoring and alarm system 1 therefore comprises at least said industrial cable 2 housing at least one pair of conductors 7a and 7b forming an electrically closed circuit together with said smart device 10, to monitor at least, e.g. in real time, the electrical continuity of said at least two conductors or plates 7a and 7b connected to each other, and to transmit said data to one or more control units or system 14 for sending at least one alarm when said electrically continuous circuit formed by said at least two conductors 7a and 7b is interrupted.

Said smart device 10, in at least one of its preferred embodiments, may comprise at least one microprocessor, a power supply battery, wireless communication means 15 and means for connecting said conductors 7a and 7b. Advantageously, in some particularly preferred embodiments, said smart device 10 may further comprise at least one accelerometer to monitor the number of cycles actually performed by the monitored cable 2.

Even more advantageously, in some embodiments, said smart device 10 might further comprise at least one temperature-detecting sensor. As already known to those skilled in the art, the operating temperature of industrial cables is essential for the correct operation of said cables. If, for example, the operating temperature fell below a certain value, for example -30°C, the outer sheath could crystallize, and once come back to higher temperatures it could crack and get damaged, thus causing a cable breakage. The operating temperature is usually constant along the cable, so that only one temperature detecting sensor housed e.g. in this smart device 10, as previously stated, is needed.

Obviously, if said smart device 10 includes also at least one accelerometer and at least one temperature sensor, also said data would be detected at intervals or in real time and transmitted at intervals or in real time to a suitable control unit or control system. Therefore, these further data would also be advantageously used to accurately check the working conditions of said industrial cables, thereby preventing their breakage or any serious damage. This innovative monitoring and alert system 1 can therefore advantageously monitor the actual working conditions of industrial cables even when they are housed in sheaths or cable chains, in real time and based on actual data and not on mere statistical assessments.

More advantageously, it is possible to set the monitoring and alert system 1 according to the customer's needs. In fact, the system can be set to send the detected information in real time, at time intervals, or only in case of an alert about a cable wear, i.e. about an interruption of the circuit formed by the conductors, and/or about having reached the total number of life cycles of the monitored industrial cable (for a possible preventive replacement) and/or about reaching particularly high or particularly low temperature thresholds that could damage the industrial cable due to its physical characteristics.

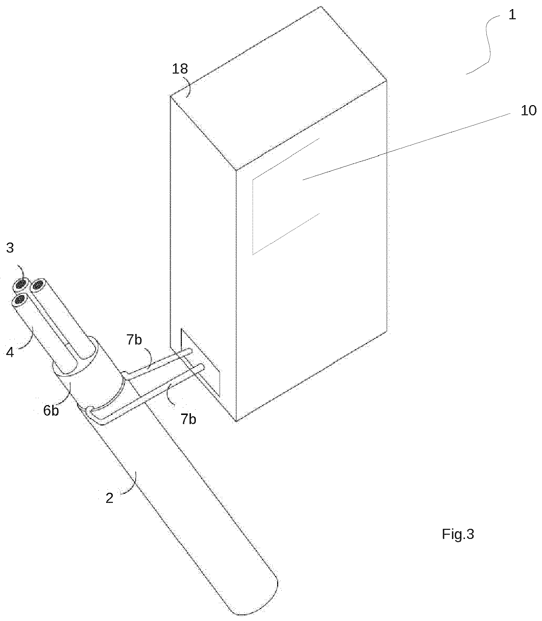

In a variant of a preferred embodiment shown in Figure 3, said monitoring and alert system 1 for dynamic industrial cables includes also in this case at least two conductors 7a and 7b to form an electrically closed circuit arranged along the length of said cable 2, preferably between said first layer of insulating material 6 and said second layer of insulating material 6b.

In particular, in this embodiment, the smart device 10 is separate from the cable 2 it monitors. Said smart device 10 may be integrated with a standard industrial power supply 18 and can be used to perform tests on the cable 2 provided with conductors according to the present invention, one-off or at regular intervals to check whether the electrically closed circuit formed by said at least two conductors is intact, so that the cable is working properly and shows no relevant abrasion, or whether the cable is damaged and the circuit is open. In case of damage, since tests are usually performed at regular intervals, it will advantageously be possible to act on the damage before the cable is badly damaged. Obviously, said smart device 10 can transmit said data in any suitable mode, wireless or via cable, etc., or it may emit an alarm signal in case of breakdown, so that the operator performing the control is promptly alerted.

In a further innovative variant, the smart device 10 may be integrated in the connector 12 of the industrial cable 2 in an extremely simple and advantageous way by easily inserting the components of said device in the structure of the connector 12.

Therefore, particularly advantageously, the monitoring and alarm system 1 described in the present invention can monitor industrial cables and, more particularly, can effectively control the cable by means of actual measurements, not based on statistical data. More advantageously, said system may be simply integrated in industrial cables and is inexpensive to manufacture, besides being particularly efficient and reliable on all types of industrial cables, be they housed in a sheath or in a cable chain or otherwise used.

It is therefore clear that variants included in the object of the present invention as described by the appended claims are to be considered all types of industrial cables e.g. multipole, power supply cables for motors and servomotors (including versions with brake and/or temperature probe), feedback cables for motors and servomotors, encoder and resolver cables, data bus cables, hybrid cables (power, and/or bus and/or feedback), auxiliary input/output cables, sensor cables, as well as variations in materials, diameters, physical characteristics of said cables, provided that said cables are for industrial use, as well as variations in the shape or size or position of said smart device 10, provided that it is capable of detecting the condition of said cable 2, as well as variations in the data transmitting mode from said cable 2 to said device and/or from said device 10 to a suitable control system or the like.

## Claims

1. A monitoring and alert system (1) for industrial cables (2) comprising at least a pair of conductors (7a, 7b) to be arranged along the length of said industrial cable (2), said at least one pair of conductors (7a, 7b) being interposed between a first layer (6a) and a second layer (7b) of insulating material enveloping said cable (2), said pair of conductors forming an electrically closed circuit, and comprising at least means for detecting the opening of said circuit,
**characterized in that** said means for detecting the opening of said at least one circuit are included in a smart device (10) suitable at least for detecting and monitoring in real time the state of the circuit formed by said conductors (7a, 7b) during a dynamic operating phase of said industrial cable (2), for monitoring the actual wear conditions of said industrial cable (2).

2. The monitoring and alert system (1) for industrial cables (2) according to claim 1, wherein said smart device (10) comprises means for transmitting at least detected data relating to the opening of said circuit, at least in wireless mode (15).

3. The monitoring and alert system (1) for industrial cables (2) according to claims 1 and 2, wherein said smart device (10) comprises at least a temperature sensor for measuring the operating temperature of at least one industrial cable (2) on which it is arranged.

4. The monitoring and alert system (1) for industrial cables (2) according to the preceding claims, wherein said smart device (10) comprises at least one accelerometer for measuring in real time the number of working cycles of said at least one industrial cable (2) on which it is arranged.

5. The monitoring and alert system (1) for industrial cables (2) according to the preceding claims, wherein said smart device (10) can be arranged on said at least one industrial cable (2) or can be integrated in at least one connector (12) of said industrial cable (2).

6. The monitoring and alert system (1) for industrial cables (2) according to the preceding claims, wherein said smart device (10) is integrated within a standard power supply for industrial use (18) and can perform one-off or regular-interval tests on the industrial cable (2) to check at least the condition of said at least one electrically closed circuit formed by said at least one pair of conductors (7a, 7b).

7. The monitoring and alert system (1) for industrial cables (2) according to the preceding claims, wherein said smart device (10) comprises alert means for generating an alarm when detecting the interruption of said at least one electrically closed circuit.

8. The monitoring and alert system (1) for industrial cables (2) according to the preceding claims, wherein said at least one pair of conductors (7a, 7b) are wound coil-like along the length of the industrial cable (2).

9. The monitoring and alert system (1) for industrial cables (2) according to the preceding claims, wherein said at least one pair of conductors or conductive plates (7a, 7b) is arranged along the industrial cable (2) following its longitudinal development.

10. The monitoring and alert system (1) for industrial cables (2) according to the preceding claims, wherein said system comprises one or more pairs of conductors (7a, 7b) arranged along the cable following the longitudinal development or length of said industrial cable (2) to obtain the maximum coverage of the surface of the industrial cable (2) to detect any possible abrasion or breaking.
